## Europäisches Patentamt

## European Patent Office

## Office européen des brevets

(19)

(11) Veröffentlichungsnummer: **0 153 614**
**B1**

# EUROPÄISCHE PATENTSCHRIFT

(12)

(45) Veröffentlichungstag der Patentschrift:
**06.12.89**

(21) Anmeldenummer: **85101147.8**

(22) Anmeldetag: **04.02.85**

(51) Int. Cl.⁴: **G 01 R 29/16**

(54) **Verfahren und Anordnung zur Bestimmung des Mit- und Gegenkomponentenstromes in einem unsymmetrisch belasteten Netz.**

(30) Priorität: **07.02.84 SE 8400621**

(43) Veröffentlichungstag der Anmeldung:
**04.09.85 Patentblatt 85/36**

(45) Bekanntmachung des Hinweises auf die Patenterteilung:
**06.12.89 Patentblatt 89/49**

(84) Benannte Vertragsstaaten:
**CH DE FR GB IT LI**

(56) Entgegenhaltungen:
**US-A-3 699 441**

**MESSTECHNIK, Band 77, Nr. 59, Juli/August 1969, Seiten 192-195, Prag, CS; R. DRECHSLER: "Errechnen der symmetrischen Stromkomponenten in Dreiphasensystemen aus der gemessenen Wirk- und Blindleistung"**

(73) Patentinhaber: **ASEA AB, S-721 83 Västeras (SE)**

(72) Erfinder: **Jacobsson, Curt, Ragnar Lodbroks väg 7, S-723 55 Västeras (SE)**

(74) Vertreter: **Boecker, Joachim, Dr.- Ing., Rathenauplatz 2-8, D-6000 Frankfurt a.M. 1 (DE)**

EP 0 153 614 B1

**Beschreibung**

Die vorliegende Erfindung betrifft ein Verfahren und eine Anordnung zur Bestimmung des Mit- und Gegenkomponentenstromes in einem unsymmetrisch belasteten Netz gemäß dem Oberbegriff der Ansprüche 1 und 5.

Der Strom, den ein Generator ans Netz liefert, ist in der Regel in allen Phasen gleich groß. Die Phasenverschiebung zwischen den Strömen ist ebenfalls in der Regel gleich groß und beträgt bei Drehstromnetzen 120 Grad. Bei unsymmetrischer Belastung des Netzes, bei Unterbrechung einer Phase oder bei unnormalen Betriebsverhältnissen, wie zum Beispiel ein- oder zweiphasigen Kurzschlüssen, werden die Ströme unsymmetrisch. Es ist bekannt, daß Dreiphasenmaschinen verschiedener Art gegen Schieflast sehr empfindlich sind und durch große Schieflasten zerstört werden können.

Ein Maß für den Grad der Schieflast ist der sogenannte Gegenkomponentenstrom. Hierbei handelt es sich um ein gedachtes symmetrisches Dreiphasenstromsystem mit umgekehrter Phasenfolge. Durch Addition dieses gegenläufigen er linksläufigen Stromsystems mit einem zweiten ebenfalls gedachten symmetrischen Dreiphasenstromsystem mit normaler Phasenfolge, dem sogenannten Mitkomponentenstrom (rechtsläufiges oder mitläufiges System), dessen Ströme die gleiche oder eine andere Amplitude haben als die des linksläufigen Systems, erhält man das wirkliche, die Schief last darstellende unsymmetrische System. Mit anderen Worten: Das unsymmetrische dreiphasige Stromsystem läßt sich in ein rechtsläufiges und ein linksläufiges symmetrisches Stromsystem zerlegen mit unterschiedlicher, d.h. linksläufiger bzw. rechtsläufiger Phasenfolge. Entsprechend erzeugt das gegenläufige Stromsystem ein gegenläufiges magnetisches Drehfeld (Stator-MMK), dessen Drehzahl im Verhältnis zum Stator gleich groß wie die des mitlaufenden normalen Drehfeld ist, das jedoch in entgegengesetzter Richtung rotiert. Im Läufer induziert dieses sogenannte inverse Drehfeld daher Spannungen von doppelter Netzfrequenz. Diese Spannungen treiben in den Metallteilen des Rotors, wie z. B. der Dämpferwicklung, relativ große Ströme von doppelter Netzfrequenz. Durch die dadurch verursachte Wärmeentwicklung wird der Rotor beschädigt, wenn der Gegenkomponentenstrom groß genug ist und lange genug wirksam ist.

Um eine Maschine gegen Schäden infolge Schieflast zu schützen, gibt es einen sogenannten Gegenkomponentenstromschutz, der auf der Messung des Gegenkomponentenstroms beruht. Zur Ermittlung des Gegenkomponentenstroms enthalten die bekannten Gegenkomponentenstromschutzeinrichtungen eine Meßanordnung in Form eines Filters, das aus Widerständen und Induktivitäten oder Kondensatoren aufgebaut ist.

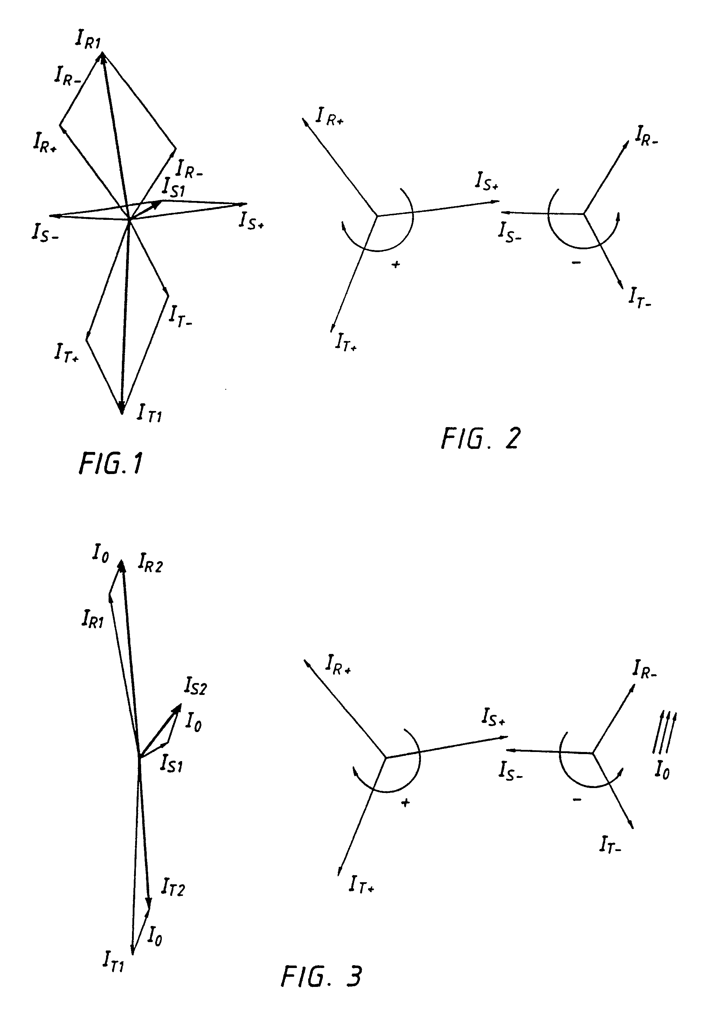

Das Verfahren bei der Zerlegung eines unsymmetrischen Dreiphasenstroms in das symmetrische Gegenkomponentenstromsystem und Mitkomponentenstromsystem ist unterschiedlich in Abhängigkeit davon, ob das Netz geerdet ist oder nicht. Bei nicht geerdetem Netz zerfällt das unsymmetrische Stromsystem (Schieflastsystem) - wie oben erläutert - in ein gegenläufiges Gegensystem und ein mitläufiges Mitsystem. Figur 1 zeigt das Zeigerdiagramm der Ströme für eine unsymmetrische Belastung, während Figur 2 das entsprechende Mitsystem und Gegensystem mit angegebener Phasenfolge bei nicht geerdetem Netz zeigt.

Bei geerdetem Netz tritt bei unsymmetrischer Belastung noch ein Nullkomponentenstrom auf, was bedeutet, daß bei der Zerlegung der Schieflastströme zusätzlich ein Nullsystem vorhanden ist, das aus drei hinsichtlich Größe und Phase gleichen Einphasenströmen besteht. Figur 3 zeigt im rechten Teil die drei Stromsysteme, in die ein unsymmetrisches Stromsystem (links in Figur 3) bei geerdetem Netz zerlegt werden kann.

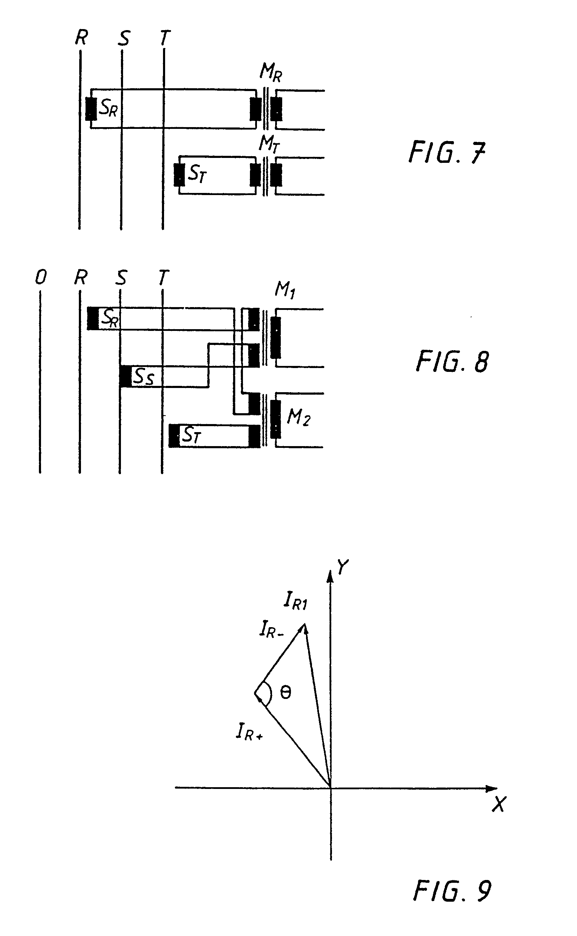

Da die Phasenströme des Gegensystems untereinander gleich groß sind, genügt es, einen derselben zu ermitteln. In einem nicht geerdetem Netz kann, wie beschrieben werden soll, der Gegenkomponentenstrom oder eine diesem Strom proportionale Größe mit Hilfe von zwei Phasenströmen des Netzes gemessen werden. In einem geerdeten Netz müssen - wie aus dem folgenden hervorgeht (siehe Figur 8) - sämtliche Phasenströme in einer speziellen Schaltung gemessen werden, um den Gegenkomponentenstrom zu ermitteln.

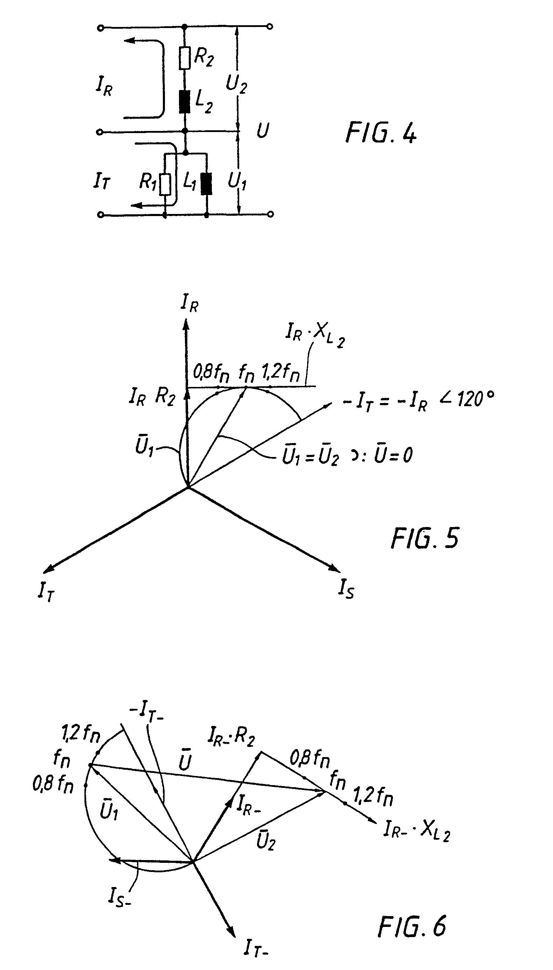

Die Zerlegung der Phasenströme zur Gewinnung eines Maßes für den Gegenkomponentenstrom geschieht gemäß bekannter Technik durch sog. Gegenkomponentenstromfilter. Ein solches Filter ist in der SE-A-3 69 232 (US-A-3 699 441) beschrieben. Eine Variante dieses Filters soll etwas genauer beschrieben werden. Die Schaltung des Filters geht aus Figur 4 hervor. Zu ihr gehört ein Wirkwiderstand $R_1$, der parallel zu einer Induktivität $L_1$ liegt. Diese Parallelschaltung wird von einem Strom durchflossen, der dem Phasenstrom $I_T$ entspricht, wodurch an der Parallelschaltung eine Spannung $U_1$ auftritt. Zu dem Filter gehört ferner eine Reihenschaltung aus einer Induktivität $L_2$ und einem Wirkwiderstand $R_2$, die von einem dem Phasenstrom $I_R$ entsprechenden Strom durchflossen wird. Die an der Reihenschaltung auftretende Spannung ist mit $U_2$ bezeichnet. Durch geeignete Bemessung der Schaltungselemente des Filters kann erreicht werden, daß das Ausgangssignal $U$ des Filters Null ist, wenn das Netz symmetrisch belastet ist, also kein Gegenkomponentenstrom vorhanden ist. Wenn dagegen ein Gegenkomponentenstrom vorhanden ist, dann nimmt das Ausgangssignal $U$ einen Wert an, der dem Gegenkomponentenstrom proportional ist.

Bei symmetrisch belastetem Netz haben alle Phasenströme $I_R$, $I_S$, $I_T$ gleiche Größe und sind um 120 Grad gegeneinander phasenverschoben (siehe Figur 5). Macht man den Phasenstrom $I_R$ zur Bezugsphase, so ist der Realteil $I_R R_2$ der Spannung $U_2$ in Phase mit dem Strom $I_R$ und der Imaginärteil $I_R X_{L2}$ ist um 90 Grad gegenüber $I_R$ phasenverschoben. Da der Blindwiderstand $X_{L2}$ frequenzabhängig ist, ist die Ortskurve für $I_R X_{L2}$ eine Gerade, auf welcher der Wert für $I_R X_{L2}$ für die Nennfrequenz $f_n$, $0,8 \cdot f_n$ und $1,2 \cdot f_n$ eingetragen ist.

Bei den in Figur 4 eingetragenen Stromrichtungen muß zur Bestimmung von $U_1$ von dem Phasenstrom $-I_T$, d.h. $-I_R < 120$ Grad, ausgegangen werden. Die Ortskurve für $U_1$ ist dann ein Halbkreis, auf dessen Umfang der Endpunkt des Vektors $U_1$ für die Nennfrequenz $f_n$, $0,8 \cdot f_n$ und $1,2 \cdot f_n$ eingetragen ist.

Bei geeigneter Dimensionierung und Trimmung wird $U_1 = U_2$, und da $U$ die Spannung zwischen den Endpunkten der Vektoren $U_1$ und $U_2$ ist, wird $U$ = Null.

Bei der Untersuchung der Verhältnisse bei unsymmetrischer Belastung kann man von dem Gegenkomponentenstromdiagramm gemäß Figur 2 ausgehen. Macht man, wie in Figur 6, $I_R$- zur Bezugsphase, so wird die Spannung $U_2$ in gleicher Weise gebildet, wie bei dem zuvor beschriebenen symmetrischen Fall. Wegen der umgekehrten Phasenfolge des Gegenkomponentenstroms und der in Figur 4 angegebenen Stromrichtung für $I_T$ muß auch hier von $-I_T$-, d.h. von $-I_R$ < 240 Grad, ausgegangen werden. Die Ortskurve für $U_1$ ist der in Figur 6 gezeigte Halbkreis. Das Ausgangssignal U des Filters geht aus der Figur hervor, und der Betrag des Vektors (Absolutwert) ist dem Gegenkomponentenstrom proportional und somit ein Maß für diesen Strom.

Die Speisung des Gegenkomponentenstromfilters der beschriebenen Art für ein nicht geerdetes Netz zeigt Figur 7. Außer den Stromwandlern $S_R$ und $S_T$ sind Zwischentransformatoren $M_R$ und $M_S$ vorhanden.

Bei einem geerdeten System müssen zur Eliminierung eines eventuell auftretenden Nullkomponentenstromes sämtliche Phasenströme gemessen werden, was durch die Stromwandler $S_R$, $S_S$ und $S_T$ geschieht (siehe Figur 8). Ferner sind Zwischentransformatoren $M_1$ und $M_2$ vorhanden.

Gegenkomponentenstromfilter, wie das zuvor beschriebene und die in der SE-A-369 232 beschriebenen haben gewisse Nachteile. Wie aus Figur 5 hervorgeht, liefert das Filter auch bei symmetrisch belastetem Netz ein Ausgangssignal, wenn sich die Frequenz verändert, da dann $U_1$ und $U_2$ nicht mehr gleich groß sind. Auch bei transienten Vorgängen im Netz kann das Filter ein Ausgangssignal liefern, ohne daß ein Gegenkomponentenstrom im Netz vorhanden ist. Ferner können im Netz vorhandene Oberwellen zur Folge haben, daß das Filter ein Ausgangssignal aufgrund verschiedener Frequenzgänge in den drei Phasen liefert. Solche Fehlanzeigen können einen falschen Alarm, eine Blockierung oder eine Auslösung verursachen.

Aus der Druckschrift "Meßtechnik", Bond 77, Nr. 59, Juli / August, 1969 Seiten 192 bis 195 ist ein Verfahren zur Bestimmung der symmetrischen Stromkomponenten in geerdeten und nicht geerdeten Netzen bekannt, gemäß welchem der Mitkomponentenstrom und der Gegenkomponentenstrom aus gemessenen Wirkleistungs- und Blindleistungswerten errechnet werden. Die Durchführung dieses Verfahrens erfordert relativ aufwendige Wirk- und Blindleistungsmesser, und die Genauigkeit des Verfahrens ist von der Spannungssymmetrie des Drehstromnetzes abhängig.

Der Erfindung liegt die Aufgabe zugrunde, ein Verfahren der eingangs genannten Art zu entwickeln, bei dem die für einen Gegenkomponentenstromschutz erforderliche Ermittlung des Gegenkomponentenstroms ohne Induktivitäten oder Kondensatoren und ohne Wirk- und Blindleistungsmeßgeräte durchführbar ist.

Zur Lösung dieser Aufgabe wird ein Verfahren gemäß dem Oberbegriff des Anspruches 1 vorgeschlagen, welches erfindungsgemäß die im kennzeichnenden Teil des Anspruches 1 genannten Merkmale hat.

Vorteilhafte Ausgestaltungen des Verfahrens sind in den weiteren Ansprüchen 2 bis 4 genannt.

Der Erfindung liegt ferner die Aufgabe zugrunde, eine Anordnung zur Durchführung eines Verfahrens der eingangs genannten Art zu entwickeln, bei der die für einen Gegenkomponentenstromschutz erforderliche Ermittlung des Gegenkomponentenstrom ohne Induktivitäten oder Kondensatoren und ohne Wirk- und Blindleistungsmeßgeräte durchgeführt wird.

Zur Lösung dieser Aufgabe wird eine Anordnung gemäß dem Oberbegriff des Anspruches 5 vorgeschlagen, welche erfindungsgemäß die im kennzeichnenden Teil des Anspruches 5 genannten Merkmale hat.

Vorteilhafte Ausgestaltungen der Anordnung sind in den Ansprüchen 6 bis 7 genannt.

Wie aus den obigen Ausführungen hervorgeht, kann bei unsymmetrisch belastetem Netz der Strom jeder Phase in einen Gegenkomponentenstrom und einen Mitkomponentenstrom und - bei geerdetem Netz - zusätzlich in einen Nullkomponentenstrom zerlegt werden. In einem System nach den Figuren 1 und 2 ist $I_{R1}$ in die Komponenten $i_{R+}$ und $I_R$- zerlegt, die einen Winkel θ zwischen sich bilden (siehe Figur 9). Der Zusammenhang zwischen $I_{R1}$, $I_{R+}$ und $I_R$- kann mit Hilfe des Cosinustheorems beschrieben werden. Für die Phasen S und T kann eine entsprechende Zerlegung durchgeführt werden. Für die so gewonnenen Stromkomponenten gilt $|I_{R+}| = |I_{S+}| = |I_{T+}| = |I_1|$ und $|I_R-| = |I_S-| = |I_T-| = |I_2|$, wobei die Phasenverschiebung zwischen den Mit- bzw. Gegenkomponentenströme 120 Grad beträgt. Dabei ist $I_1$ der Betrag der Mitkomponente und $I_2$ der Betrag der Gegenkomponente.

Für die Phase R gilt:

$$I^2{}_R = I_1{}^2 + I^2{}_2 - 2I_1 I_2 \cos θ$$

Entsprechende Gleichungen lassen sich für die Phasen S und T aufstellen, so daß man ein Gleichungssystem aus drei Gleichungen mit drei Unbekannten bekommt. Man kann daher durch Messung aller Phasenströme eine Anordnung schaffen, durch welche sowohl der Mit- wie Gegenkomponentenstrom sowie der Winkel berechnet werden können.

Anhand der weiteren Figuren soll die Erfindung näher beschrieben werden. Die Figuren zeigen

Figur 1    ein Beispiel für die in einem unsymmetrisch belasteten Netz auftretenden Ströme,

Figur 2    die Zerlegung der Phasenströme gemäß Figur 1 in Gegenkomponentenströme und Mitkomponentenströme bei einem nicht geerdetem Netz,

Figur 3    eine entsprechende Darstellung wie in den Figuren 1 und 2 für ein geerdetes Netz, wobei zusätzlich Nullkomponentenströme auftreten,

Figur 4    eine Ausführungsform eines Gegenkomponentenstromfilters,

Figur 5    die Zusammensetzung des Ausgangssignals des Filters bei einem symmetrisch belasteten Netz,

Figur 6    die Zusammensetzung des Ausgangssignals des Filters, welches ein Maß für den Gegenkomponentenstrom im Netz ist, für ein nicht geerdnetes unsymmetrisch belastets Netz,

Figur 7    die Stromspeisung des Filters zur Gegenkomponentenstrommessung in einem nicht geerdeten Netz,
Figur 8    Stromspeisung des Filters zur Gegenkomponentenstrommessung in einem geerdeten Netz,
Figur 9    die Zerlegung eines Phasenstromes $I_{R1}$ in den Gegenkomponentenstrom $I_{R-}$ und den Mitkomponentenstrom $I_{R+}$,
Figur 10   ein Blockschaltbild zur Berechnung des Mit- und Gegenkomponentenstroms,
Figur 11   ein Blockschaltbild zur digitalen Berechnung des Mit- und des Gegenkomponentenstroms,
Figur 12   die Schaltung der Zwischentransformatoren, durch welche die Meßanordnung unabhängig davon gemacht wird, ob das Netz geerdet ist oder nicht.

Das Gleichungssystem für sämtliche Phasenströme lautet:

$$I_R^2 = I_1^2 + I_2^2 - 2\,I_1 \cdot I_1 \cos\theta \tag{1}$$

$$I_S^2 = I_1^2 + I_2^2 - 2\,I_1 \cdot I_2 \cos(\theta - 120°) \tag{2}$$

$$I_T^2 = I_1^2 + I_2^2 - 2\,I_1 \cdot I_2 \cos(\theta + 120°) \tag{3}$$

Gleichung (2) - (1) ergibt:
$$I_S^2 - I_R^2 = 2\,I_1 \cdot I_2 \cos\theta - 2\,I_1 \cdot I_2 \cos(\theta - 120°) \tag{4}$$

Gleichung (3) - (1) ergibt:
$$I_T^2 - I_R^2 = 2\,I_1 \cdot I_2 \cos\theta - 2\,I_1 \cdot I_2 \cos(\theta + 120°) \tag{5}$$

Mit Hilfe trigonometrischer Umwandlungsformeln und Einsetzen der Werte für sin 120° und cos 120° können die Gleichungen (4) und (5) wie folgt geschrieben werden:

$$I_S^2 - I_R^2 = I_1 \cdot I_2 (3 \cos\theta + \sqrt{3} \sin\theta) \tag{6}$$

$$I_T^2 - I_R^2 = I_1 \cdot I_2 (3 \cos\theta - \sqrt{3} \sin\theta) \tag{7}$$

Durch Addition von Gleichung (6) und Gleichung (7) erhält man:

$$I_S^2 + I_T^2 - 2\,I_R^2 = 6\,I_1 \cdot I_2 \cos\theta \tag{8a}$$

$$2I_1 \cdot I_2 \cdot \cos\theta = \frac{I_S^2 + I_T^2 - 2I_R^2}{3} \tag{8b}$$

Durch Einführung von Gleichung (8b) und Gleichung (1) erhält man:

$$I_R^2 = I_1^2 + I_2^2 - \frac{I_S^2 + I_T^2 - 2I_R^2}{3} \tag{9}$$

Durch Bildung der Differenz aus den Gleichungen (6) erhält man:

$$I_S - I_T^2 = I_1 \cdot I_2 \cdot 2 \sqrt{3} \sin\theta \tag{10}$$

Der Quotient aus den Gleichungen (10) und (8a) ergibt nach gewissen Umrechnungen:

$$\tan\theta = \sqrt{3}\,\frac{I_S^2 - I_T^2}{I_S^2 + I_T^2 - 2I_R^2} \tag{11}$$

Durch Auflösung der Gleichung (10) nach $I_1$ und Einsetzen in Gleichung (1) erhält man nach entsprechender Umformung:

$$I_2^2 - \frac{I_S^2 - I_T^2}{\sqrt{3}\tan\theta} + \frac{(I_S^2 - I_T^2)^2}{12I_2^2 \sin^2\theta}\,I_R^2 = 0 \tag{12}$$

Durch Einsetzen von tan θ gemäß Gleichung (11) erhält man:

$$I_2^4 - I_2^2\,\frac{I_R^2 + I_S^2 + I_T^2}{3} + \frac{(I_S - I_T^2)^2}{12 \sin^2\theta} = 0 \tag{13}$$

Die Auflösung der Gleichung (13) nach $\sin^2 \theta$ erfolgt mit Hilfe der Gleichung (11) und ergibt nach Einsetzen in die trigonometrische Beziehung:

$$\sin^2 \theta = \frac{\tan^2 \theta}{1 + \tan^2 \theta}$$

$$\sin^2 \theta = \frac{3(I_T^2 - I_T^2)^2}{(I_S^2 + I_T^2 - 2I_R^{2)2}) + 3(I_T^2 - I_S^2)^2} \tag{14}$$

Das Einsetzen dieses Wertes in Gleichung (13) ergibt nach Umformung:

$$I_2^4 - I_2^2 \frac{I_R^2 + I_S^2 + I_T^2}{3} + \frac{I_R^4 + I_S^4 + I_T^4 - I_R^2 I_S^2 - I_R^2 I_T^2 - I_S^2 I_T^2}{9} = 0$$

Indem man:

$$2A = \frac{I_R^2 + I_S^2 + I_T^2}{3} \tag{16}$$

$$B = \frac{I_R^4 + I_S^4 + I_T^4 - I_R^2 I_S^2 - I_R^2 I_T^2 - I_S^2 I_T^2}{9} \tag{17}$$

setzt, geht Gleichung (15) über in

$$I_2^4 - 2AI_2^2 + B = 0 \tag{18}$$

Die Auflösung nach $I_2$ ergibt:

$$I_2 = \sqrt{A} \pm \sqrt{A^2 - B} \tag{19}$$

$$I_2 = \sqrt{|A \pm \sqrt{|A^2 - B|}|} \qquad I_1 = \sqrt{|A \pm \sqrt{|A^2 - B|}|} \tag{20}$$

Das unter dem Wurzelzeichen in Gleichung (20) zu verwendende Vorzeichen wird von der Phasenfolge des Netzes bestimmt. Man kann zeigen, daß die Gleichung (20) auch zur Berechnung des Mitkomponentenstroms $I_1$ verwendet kann. Die Zusammenhänge zwischen der Art des Vorzeichens unter der Wurzel, der Phasenfolge, dem Mitkomponentenstrom und dem Gegenkomponenentenstrom sind in folgender Tabelle gezeigt:

| Phasenfolge / Strom | $I_1$ | $I_2$ |
|---|---|---|
| RST | + | - |
| RTS | - | + |

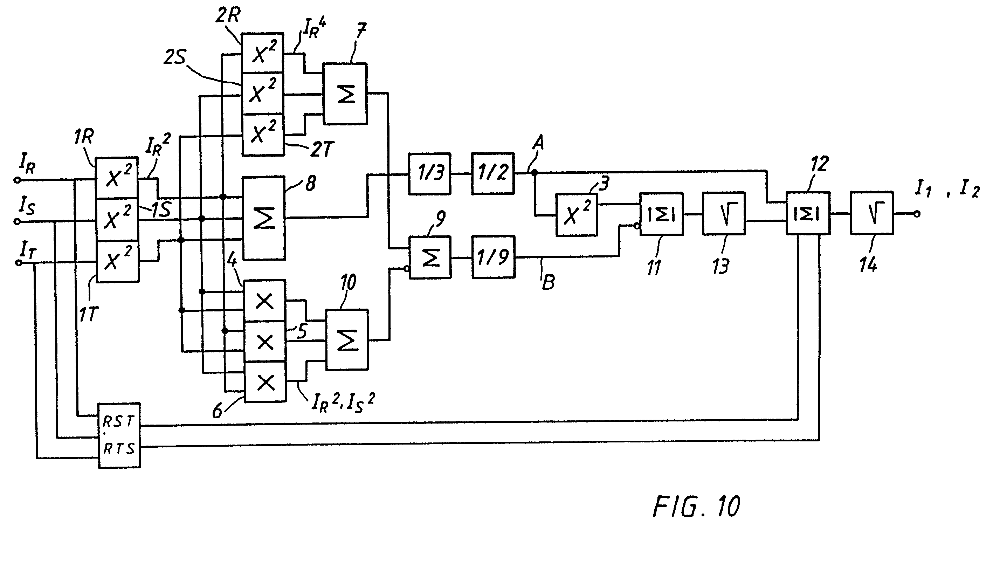

Die Rechenoperationen, die zur Berechnung von $I_1$ und/oder $I_2$ bei Kenntnis der Phasenfolge des Netzes erforderlich sind, sind relativ einfach und können auf viele verschiedene Arten ausgeführt werden. Ein Berechnungsflußschema für eine solche Berechnungsschaltung zeigt Figur 10. Die Schaltung enthält Quadrierglieder 1R, 1S, 1T, 2R, 2S, 2T und 3, Multiplikationsglieder 4, 5 und 6, Summierungsglieder 7, 8, 9 und 10, Glieder 11 und 12 zur Summierung und Absolutwertbildung sowie Glieder 13 und 14 zur Quadratwurzelbildung von Eingangssignalen. Die Phasenfolgebestimmung erfolgt durch das Glied 15. Die genannten Rechenoperationen können sowohl analog, digital oder gemischt analog-digital durchgeführt werden. Das Berechnungsflußschema nach Figur 10 kann zugleich als Blockschaltbild einer analogen Schaltungsanordnung aufgefaßt werden. Eine Vervollständigung kann durch analoge RMS-Bildung der Eingangssignale erfolgen (RMS bedeutet "root mean square" -Wert = quadratischer Mittelwert, also Effektivwert).

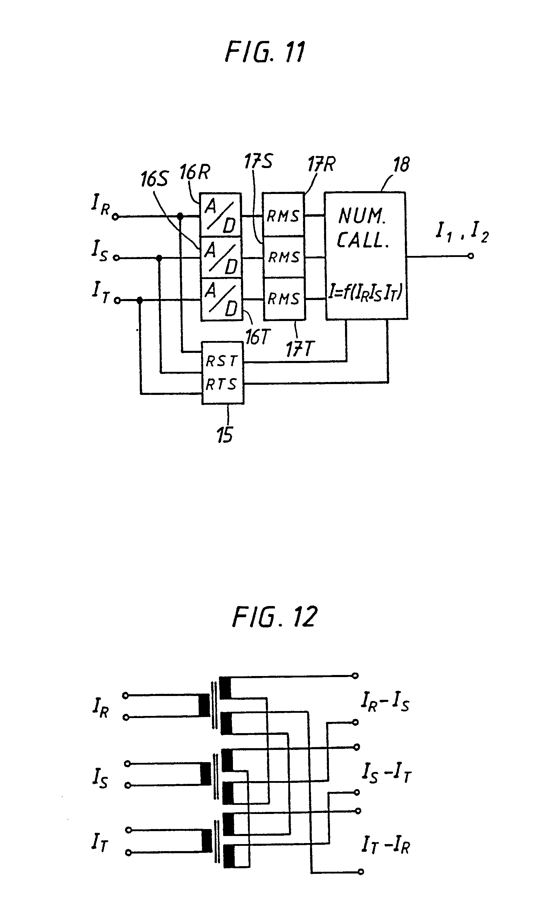

Figur 11 zeigt eine Ausführungsform in rein digitaler Technik. Die analogen Eingangssignale der Phasenströme $I_R$, $I_S$, $I_T$ werden in Analog-Digitalwandler 16R, 16S und 16T in digitale Werte umgewandelt. Die in digitale Werte umgewandelten Phasenströme werden in den RMS-Gliedern 17R, 17S und 17T RMS-behandelt und zur Ausrechnung der Gleichung (20) an einen zweckmäßig gestalteten Prozessor 18 weitergegeben, dem auch Informationen über die vorliegende Phasenfolge über das Glied 15 zugeführt werden.

Die Erfindung umfaßt verschiedene Ausführungsformen mit kleinerem oder größerem Maß an Integration der Glieder 15 bis 18 gemäß Figur 11.

Dasselbe gilt für Hybridenlösungen aus einer Mischung von analoger und digitaler Technik für die verschiedenen Glieder und Funktionen.

Wenn ein ermittelter Mit- oder Gegenkomponentenstrom einen im voraus eingestellten Wert übersteigt, kann man ein Auslösesignal erhalten. Eine Auslösung kann auch einfach entsprechend verschiedener Invertzeitkurven geschehen.

Wie aus der vorstehenden Beschreibung hervorgeht, müssen der Meßanordnung gemäß der Erfindung immer sämtliche Phasenströme zugeführt werden. Um nicht mit unterschiedlichen Eingangskreisen arbeiten zu müssen, je nachdem, ob das Netz geerdet ist oder nicht, wird in Übereinstimmung mit dem Stand der Technik eine Schaltung verwendet, die im Prinzip wie die in Figur 8 gezeigte aufgebaut ist, bei der jedoch die Primär- und Sekundärseite vertauscht sind. Diese Schaltung zeigt Figur 12, bei der die drei Phasenströme in ein äquivalentes Dreiphasensystem ohne Nullkomponente umgewandelt werden.

**Patentansprüche**

1. Verfahren zur Bestimmung des Mitkomponentenstromes $I_1$ und/oder des Gegenkomponentenstromes $I_2$ in einem unsymmetrisch belasteten, geerdeten oder nicht geerdeten Netz, bei welchem Verfahren die Phasenströme $I_R$, $I_S$, $I_T$ und die Phasenfolge (RST, RTS) gemessen werden, *dadurch gekennzeichnet*, daß aus den Meßwerten für die Phasenströme, aus welchen Meßwerten im Falle eines geerdeten Netzes zunächst der von einem eventuell vorhandenen Nullkomponentenstrom herrührende Anteil ausgeschieden wird, und dem Meßwert für die Phasenfolge der Mitkomponentenstrom $I_1$ und/oder der Gegenkomponentenstrom $I_2$ nach der Formel

$$I_{1,2} = \sqrt{|\, A \pm \sqrt{|\, A^2 - B\,|}\,|}$$

berechnet wird, wobei

$$A = \frac{I_R^2 + I_S^2 + I_T^2}{6} \quad \text{und}$$

$$B = \frac{I_R^4 + I_S^4 + I_T^4 - I_R^2 I_S^2 - I_R^2 I_T^2 - I_S^2 I_T^2}{9}$$

und $I_R$, $I_S$, $I_T$ die gemessenen, von einem eventuell vorhandenen Nullkomponentenstrom bereinigten Phasenströmen sind.

2. Verfahren nach Anspruch 1, *dadurch gekennzeichnet*, daß bei der Phasenfolge RST zur Ermittlung des Mitkomponentenstromes das Pluszeichen und zur Ermittlung des Gegenkomponentenstromes das Minuszeichen in dem genannten Wurzelausdruck verwendet wird.

3. Verfahren nach Anspruch 1 *dadurch gekennzeichnet*, daß bei der Phasenfolge RTS zur Ermittlung des Gegenkomponentenstromes das Pluszeichen und zur Ermittlung des Mitkomponentenstromes das Minuszeichen in dem genannten Wurzelausdruck verwendet wird.

4. Verfahren nach einem der vorhergehenden Ansprüche, *dadurch gekennzeichnet*, daß der Mitkomponentenstrom und/oder der Gegenkomponentenstrom mit Hilfe einer direkten, nicht iterativen Methode gewonnen werden.

5. Anordnung zur Bestimmung des Mitkomponentenstromes $I_1$ und/oder des Gegenkomponentenstromes $I_2$ in einem unsymmetrisch belasteten, geerdeten oder nicht geerdeten Netz mit Gliedern zur Messung der Phasenströme $I_R$, $I_S$, $I_T$ und der Phasenfolge (RST, RTS), *dadurch gekennzeichnet*, daß zumindest bei einem geerdeten Netz Mittel zur Ausscheidung des von einem eventuell vorhandenen Nullkomponentenstrom herrührenden Anteils in den Meßwerten der gemessenen Phasenströmen vorhanden sind und daß Berechnungsglieder vorhanden sind, in denen aus den vorgenannten von einem eventuell vorhandenen Nullkomponentenstromanteil bereinigten Phasenströmen und dem Meßwert für die Phasefolge der Mitkomponentenstrom $I_1$ und/oder der Gegenkomponentenstrom $I_2$ nach der Formel

$$I_{1,2} = \sqrt{|\, A \pm \sqrt{|\, A_2 - B\,|}\,|}$$

berechnet wird, wobei

$$A = \frac{I_R^2 + I_S^2 + I_T^2}{6} \quad \text{und}$$

$$B = \frac{I_R^4 + I_S^4 + I_T^4 - I_R^2 I_S^2 - I_R^2 I_T^2 - I_S^2 I_T^2}{9}$$

und $I_R$, $I_S$, $I_T$ die gemessenen, von einem eventuell vorhandenen Nullkomponentenstrom bereinigten Phasenströmen sind.

6. Anordnung nach Anspruch 5, *dadurch gekennzeichnet*, daß die Berechnungsglieder Quadrierglieder (1R, 1S, 1T, 2R, 2S, 2T, 3), Multiplikationsglieder (4, 5, 6), Summierungsglieder (7, 8, 9, 10), Glieder (11, 12) zur Summierung und Absolutwertbildung sowie Glieder (13, 14) zur Quadratwurzelbildung enthält.

7. Anordnung nach einem der Ansprüche 5 oder 6, *dadurch gekennzeichnet*, daß die Schaltung Analog-Digitalwandler (16R, 16S, 16T), Glieder zur RMS-Bildung (17R, 17S, 17T) und Glieder (18) zur numerischen Berechnung eines algebraischen Ausdruckes enthalten.

**Claims**

1. Method for determining the positive phase sequence current components $I_1$ and/or the negative phase sequence current components $I_2$ in an unbalanced three-phase grounded or non-grounded network with measuring the phase currents $I_R$, $I_S$, $I_T$ and the phase sequence (RST, RTS), *characterized* in that the positive phase sequence current component $I_1$ and/or the negative phase sequence current component $I_2$ are calculated from the phase current measuring values, which in the case of a grounded network are first separated from a portion originating from a possible zero sequence current component, and the measuring value of the phase sequence according to the formula

$$I_{1,2} = \sqrt{\,|\,A \pm \sqrt{|\,A^2 - B\,|}\,\,|\,}$$

with

$$A = \frac{I_R^2 + I_S^2 + I_T^2}{6} \quad \text{and}$$

$$B = \frac{I_R^4 + I_S^4 + I_T^4 - I_R^2\,I_S^2 - I_R^2\,I_T2 - I_S^2\,I_T^2}{9}$$

and $I_R$, $I_S$, $I_T$ being the measured phase currents after separation of any possible zero phase sequence current.

2. Method according to claim 1, *characterized* in that in the case of the phase sequence RST the plus sign in said square root expression is used to determine the positive phase sequence current and the minus sign is used to determine the negative phase sequence current.

3. Method according to claim 1, *characterized* in that in the case of the phase sequence RTS the plus sign in said square root expression is used to determine the negative phase sequence current and the minus sign is used to determine the positive phase sequence current.

4. Method according to any of the preceding claims, *characterized* in that the positive phase sequence current and/or the negative phase sequence current are/is obtained with the help of a direct non-iterative method.

5. Device for determining the positive phase sequence current components $I_1$ and/or the negative phase sequence current components $I_2$ in an unbalanced three-phase grounded or non-grounded network with members for measuring the phase currents $I_R$, $I_S$, $I_T$ and the phase sequence (RST, RTS), *characterized* in that at least in the case of a grounded network means are provided for separating the phase current measuring values from those portions which originate from a possible zero sequence current component, and that calculating members are provided in which the positive phase sequence current component $I_1$ and/or the negative phase sequence current component $I_2$ are calculated from the phase current measuring values, after their separation from a possible zero sequence current component, and the measuring value of the phase sequence according to the formula

$$I_{1,2} = \sqrt{\,|\,A \pm \sqrt{|\,A^2 - B\,|}\,\,|\,}$$

with

$$A = \frac{I_R^2 + I_S^2 + I_T^2}{6} \quad \text{and}$$

7

$$B = \frac{I_R^4 + I_S^4 + I_T^4 - I_R^2 I_S^2 - I_R^2 I_T^2 - I_S^2 I_T^2}{9}$$

and $I_R$, $I_S$, $I_T$ being the measured phase currents after separation of any possible zero phase sequence current.

6. Device according to claim 5, *characterized* in that the calculating members comprise squaring members (1R, 1S, 1T, 2R, 2S, 2T, 3), multiplying members (4, 5, 6), summation members (7, 8, 9, 10), members (11, 12) for adding and forming of the absolute value, and members (13, 14) for forming the square root.

7. Device according to any of claims 5 or 6, *characterized* in that the circuit comprises analog-digital converters (16R, 16S, 16T), members (17R, 175, 17T) for forming the RMS-value and members (18) for the numerical calculation of an algebraic expression.

**Revendications**

1. Procédé pour déterminer le courant à composantes directes $I_1$ et/ou du courant à composantes inverses $I_2$ dans un réseau chargé de façon dissymétrique, raccordé ou non à la terre, et selon lequel on mesure les courants de phase $I_R$, $I_S$. $I_T$ et la succession (RST, RTS) des phases, *caractérisé* en ce qu'à partir des valeurs de mesure pour les courants de phase, dans lesquelles on élimine d'abord, dans le cas d'un réseau raccordé à la terre, la partie due à un courant à composantes nulles existant éventuellement, et à partir de la valeur de mesure de la succession des phases, on calcule le courant à composantes directes $I_1$ et/ou le courant à composantes inverses $I_2$ conformément à la formule

$$I_{1,2} = \sqrt{|A \pm \sqrt{|A^2 - B|}|}$$

dans laquelle on a

$$A = \frac{I_R^2 + I_S^2 + I_T^2}{6} \quad \text{et}$$

$$B = \frac{I_R^4 + I_S^4 + I_T^4 - I_R^2 I_S^2 - I_R^2 I_T^2 - I_S^2 I_T^2}{9}$$

et $I_R$, $I_S$, $I_T$ sont les courants de phase mesurés, débarrassés d'un courant à composantes nulles éventuellement présent.

2. Procédé suivant la revendication 1, *caractérisé* par le fait que, dans le cas de la succession de phases RST, dans ladite expression en racine carrée, on utilise le signe plus pour la détermination du courant à composantes directes et le signe moins pour la détermination du courant à composantes inverses.

3. Procédé suivant la revendication 1, *caractérisé* par le fait que dans le cas de la succession de phases RTS, on utilise le signe plus pour déterminer le courant à composantes inverses et le signe moins pour déterminer le courant à composantes directes dans ladite expression en racine carrée.

4. Procédé suivant l'une des revendications précédentes, *caractérisé* par le fait qu'on obtient le courant à composantes directes et/ou le courant à composantes inverses, à l'aide d'un procédé direct, non itératif.

5. Dispositif pour déterminer le courant à composantes directes $I_1$ et/ou le courant à composantes inverses $I_2$ dans un réseau chargé de façon dissymétrique et raccordé ou non à la terre, comportant des éléments servant à mesurer le courant de phase $I_R$, $I_S$, $I_T$ et la succession des phases (RST, RTS), *caractérisé* en ce qu'au moins dans le cas d'un réseau raccordé à la terre, il est prévu des moyens pour éliminer la partie, produite par un courant à composantes nulles éventuellement présent, dans les valeurs de mesure des courants de phase mesurés, et qu'il est prévu des circuits de calcul, dans lesquels le courant à composantes directes $I_1$ ou le courant à composantes inverse $I_2$ est calculé, à partir des courants de phase indiqués précédemment, débarrassés d'une partie de courant à composantes nulles éventuellement présente, et de la valeur de mesure pour la succession des phases conformément à la formule

$$I_{1,2} = \sqrt{|A \pm \sqrt{|A^2 - B|}|}$$

dans laquelle

$$A = \frac{I_R^2 + I_S^2 + I_T^2}{6} \quad \text{et}$$

$$B = \frac{I_R^4 + I_S^4 + I_T^4 - I_R^2 I_S^2 - I_R^2 I_T^2 - I_S^2 I_T^2}{9}$$

et $I_R$, $I_S$, $I_T$ sont les courants de phase mesurés, débarrassés d'un courant 6 composantes nulles éventuellement présent.

6. Dispositif suivant la revendication 5, *caractérisé* par le fait que les circuits de calcul incluent des circuits d'élévation au carré (1R, 1S, 1T, 2R, 2S, 2T, 3), des circuits multiplicateurs (4, 5, 6), des circuits additionneurs (7, 8, 9, 10), des circuits (11, 12) servant à réaliser une addition et une formation d'une valeur absolue ainsi que des circuits (13, 14) servant a former la racine carrée.

7. Dispositif selon l'une des revendications 5 ou 6, *caractérisé* en ce que le circuit contient un convertisseur analogique/numérique (16R, 16S, 16T), des circuits (17R, 17S, 17T) servant à former la valeur efficace et des circuits (18) servant à réaliser le calcul numérique d'une expression algébrique.

EP 0 153 614 B1

FIG.1

FIG. 2

FIG. 3

FIG. 4

FIG. 5

FIG. 6

FIG. 7

FIG. 8

FIG. 9

FIG. 10

EP 0 153 614 B1

# FIG. 11

# FIG. 12